# EUROPEAN PATENT SPECIFICATION

(11) **EP 1 323 185 B1**
(45) Date of publication and mention of the grant of the patent: **27.07.2011**
(21) Application number: 01977868.7
(22) Date of filing: 01.10.2001
(51) Int. Cl.: H01L 21/28

(54) **METHOD OF FABRICATING AN OXIDE LAYER ON A SILICON CARBIDE LAYER UTILIZING N2O**
VERFAHREN ZUR HERSTELLUNG VON EINER OXYDSCHICHT AUF EINEM SILIZIUMKARBIDSCHICHT MITTELS N2O
PROCEDE DE PRODUCTION D'UNE COUCHE D'OXYDE SUR UNE COUCHE DE CARBURE DE SILICIUM AU MOYEN DE N20

(30) Priority: 03.10.2000 US 237822 P; 03.10.2000 US 237426 P; 12.04.2001 US 834283; 30.05.2001 US 294307 P
(43) Date of publication of application: 02.07.2003
(73) Proprietor: CREE, INC., Durham, North Carolina 27703-8475 (US)
(72) Inventor: LIPKIN, Lori, Raleigh, NC 27612 (US); DAS, Mrinal, Kanti, Durham, NC 27713 (US); PALMOUR, John, W., Raleigh, NC 27606 (US)
(74) Representative: Cross, Rupert Edward Blount
(86) International application number: PCT/US2001/042414
(87) International publication number: WO 2002/029874

(56) References cited:
- US-A- 5 972 801
- CHAKRABORTY S ET AL: "Interface properties of N/sub 2/O-annealed SiO/sub 2//SiC system" PROCEEDINGS 2000 IEEE HONG KONG ELECTRON DEVICES MEETING (CAT. NO.00TH8503), PROCEEDINGS 2000 IEEE HONG KONG ELECTRON DEVICES MEETING, HONG KONG, CHINA, 24 JUNE 2000, pages 108-111, XP002195736 2000, Piscataway, NJ, USA, IEEE, USA ISBN: 0-7803-6304-3
- XU J P ET AL: "IMPROVED PERFORMANCE AND RELIABILITY OF N2O-GROWN OXYNITRIDE ON 6H-SIC" IEEE ELECTRON DEVICE LETTERS, IEEE INC. NEW YORK, US, vol. 21, no. 6, June 2000 (2000-06), pages 298-300, XP000951967 ISSN: 0741-3106 cited in the application
- LAI P T ET AL: "Interface properties of N/sub 2/O-annealed NH/sub 3/-treated 6H-SiC MOS capacitor" PROCEEDINGS 1999 IEEE HONG KONG ELECTRON DEVICES MEETING (CAT. NO.99TH8458), PROCEEDINGS 1999 IEEE HONG KONG ELECTRON DEVICES MEETING, SHATIN, HONG KONG, 26 JUNE 1999, pages 46-49, XP002195737 1999, Piscataway, NJ, USA, IEEE, USA ISBN: 0-7803-5648-9
- LIPKIN L ET AL: "Challenges and state-of-the-art of oxides on SiC" SILICON CARBIDE - MATERIALS, PROCESSING AND DEVICES. SYMPOSIUM (MATERIALS RESEARCH SOCIETY SYMPOSIUM PROCEEDINGS VOL.640), SILICON CARBIDE - MATERIALS, PROCESSING AND DEVICES. SYMPOSIUM, BOSTON, MA, USA, 27-29 NOV. 2000, pages H3.1.1-10, XP008002243 2001, Warrendale, PA, USA, Mater. Res. Soc, USA ISBN: 1-55899-550-1
- JAMET P ET AL: "Physical properties of N/sub 2/O and NO-nitrided gate oxides grown on 4H SiC" APPLIED PHYSICS LETTERS, 16 JULY 2001, AIP, USA, vol. 79, no. 3, pages 323-325, XP002195738 ISSN: 0003-6951

## Description

The present invention relates to the fabrication of semiconductor devices and more particular, to the fabrication of oxide layers on silicon carbide (SIC).

Devices fabricated from silicon carbide are typically passivated with an oxide layer, such as SiO_{2,} to protect the exposed SiC surfaces of the device and/or for other reasons. However, the interface between SiC and SiO₂ may be insufficient to obtain a high surface mobility of electrons. More specifically, the interface between SiC and SiO₂ conventionnaly exhibits a high density of interface states, which may reduce surface electron mobility.

Recently, annealing of a thermal oxide in a nitric oxide (NO) ambient has shown promise in a planar 4H-SiC MOSFET structure not requiring a p-well implant. see M.K. Das, L.A. Lipkin,J.W. Palmour, G.Y. Chung. J.R. Williams, K. McDonald, and L C. Feldman, "High Mobility 4H-SiC Inversion Mode MOSFETs Using Thermally Grown, NO Annealed SiO2," IEEE Device Research Conference, Denver, CO, June 19-21, 2000 and G.Y. Chung. C.C. tin, J.R. Williams, K. McDonald, R. A. Weller, S. T. Pantelides, L C. Feldman, M. K. Das, and J. W. Palmour, "Improved Inversion Channel Mobility for 4H-SiC MOSFETs Following High Temperature Anneals in Nitric Oxide," IEEE Electron Device Letters accepted for publication. This anneal is shown to significantly reduce the interface state density near the conduction band edger G.Y. Chung. C.C. Tin, J.R. Williams, K. McDonald, M. Di Ventra, S. T.Pantdides, L. C. Feldman, and R.A. Weller, "Effect of nitric oxide annealing on the interface trap densities near the band edges in the 4H polytype of silicon carbide," Applied Physics Letters, Vol. 76, No.13,pp.1713-1715, March 2000. High electron mobility (35-95cm²/Vs) is obtained in the surface inversion layer due to the improved MOs interface.

Unfortunately,NO is a health hazard having a National Fire Protection Association (NFPA) health danger rating of 3, and the equipment in which post-oxidation anneals are typically performed is open to the atmosphere of the cleanroom. They are often exhausted, but the danger of exceeding a safe level of NO contamination in the room is not negligible.

Growing the oxide in N₂O is possible as described in J.P. Xn, P.T. Lsi, C.L. Chan, B. Li, and Y.C. Cheng, "Improved Performance and Reliability of N2O-GroWn. Oxynitride on 6H- SiC," IEEE Electron Device Letters, Vol. 21, No.6, pp.298-300, June 2000. Xn et al. describe oxidizing SiC at 1100°C for 360 minutes in a pure N₂O ambient and annealing in N₂ for 1 hour at 1100°C.

Post-growth nitridation of the oxide an 6H-SiC in N₂O at a temperature of 1100°C has also been investigated by Lai, *et al*. P.T. Lai, Supratic Chakraborty, C.L. chan, and Y.C. Cheng. "Effects of nitridation and annealing on the interface properties of thermally oxidized SiO2/SiC metal-semiconductor system," applied Physics Letters Vol. 76, No. 25, pp.33744-3746, June 2000. However, Lai *et al*. concluded that such treatment deteriorates the interface quality which may be improved with a subsequent wet or dry anneal in O₂ which may repair the damage induced by nitridation in N₂O. Moroever, even with a subsequent O₂ anneal, Lai *et al*. did not see any significant reduction in interface state density as compared to the case without nitridation in N₂O.

Lipkin, Das and Palmour "Challenges and State-of-the-Art on Oxides on SiC", Materials Research Soc. Proc. Vol. 640, ppH3.1.1-9 discloses the nitridation of an SiC: SiO₂ interface by annealing at up to 1200°C in N₂O, preferred to NO.

### Summary of the Invention

The present invention provides methods for fabricating a layer of oxide on a silicon carbide layer by at least one of oxidizing the silicon carbide layer in an N₂O environment or annealing an existing oxide layer on the silicon carbide layer in an N₂O enviromnent as defined in claim 1. Particular embodiments are defined in the dependant claims.

### Brief Description of the Drawings

**Figure 1** is a schematic illustration of a furnace tube suitable for use in the present invention;
**Figure 2A** is a flowchart illustrating processing steps according to anneal embodiments of the present invention;
**Figure 2B** is a flowchart illustrating processing steps according to oxidation embodiments of the present invention;
**Figure 3** is a graph illustrating the interface trap density versus energy level from the conduction band (E_{C}-E) for various flow rates of N₂O at 1175°C;
**Figure 4** is a graph of interface trap density (D_{IT}) versus energy level from the conduction band for various flow rates at 1200°C;
**Figure 5** is a graph of D_{IT} versus energy level from the conduction band for various anneal temperatures;
**Figure 6** is a graph of D_{IT} versus energy level from the conduction band at 1175°C for anneals of various different durations;
**Figure 7** is a graph of D_{IT} versus energy level from the conduction band for a post-treatment anneal in Ar and N₂;
**Figure 8** is a graph of D_{IT} versus energy level from the conduction band for an initial thermal oxide and an initial LPCVD oxide;
**Figure 9** is a graph of D_{IT} versus energy level from the conduction band for oxide layers formed with and without a wet reoxidation; and
**Figure 10** is a graph of D_{IT} versus energy level from the conduction band at 1175°C for anneals of various different durations.
**Figure 11** is a graph illustrating the interface trap density (Dit) versus energy level from the conduction band (E_{C}-E) for various anneal temperatures;
**Figure 12** is a graph of D_{IT} versus energy level from the conduction band for various thermal oxidation, post-growth N₂O anneals and N₂O oxidation;
**Figure 13** is a graph of effective surface channel mobility versus gate voltage for 4H-SiC planar MOSFETs with and without N₂O processing;
**Figure 14** is a graph of interface states for the oxides of **Figure 13****;**
**Figures 15A** and **15B** are graphs of the effective Surface Channel Mobility for horizontal channel buffered gate devices fabricated with N₂O grown oxides according to embodiments of the present invention;
**Figures 16A** and **16B** are graphs of the effective Surface Channel Mobility of lateral metal-oxide-semiconductor field effect transistors fabricated with N₂O grown oxides according to embodiments of the present invention; and
**Figures 17A,17B** and **17C** are graphs of effective channel mobility at different gate biases for devices having oxide layers fabricated according to embodiments of the present invention.

### Detailed Description of the Invention

The present invention now will be described more fully hereinafter with reference to the accompanying drawings, in which preferred embodiments of the invention are shown. In the drawings, the thickness of layers and regions are exaggerated for clarity. Like numbers refer to like elements throughout. It will be understood that when an element such as a layer, region or substrate is referred to as being "on" another element, it can be directly on the other element or intervening elements may also be present. In contrast, when an element is referred to as being "directly on" another element, there are no intervening elements present.

Embodiments of the present invention provide methods which may improve the interface between an oxide layer and SiC in any device which includes such an interface. These methods are especially advantageous in the fabrication of Metal-Oxide-Semiconductor (MOS) devices created on SiC. Using embodiments of the present invention, interface states with energy levels near the conduction band of SiC may be dramatically reduced. Reduction of such defects may be advantageous, because these defects may limit a MOSFET's effective surface channel mobility.

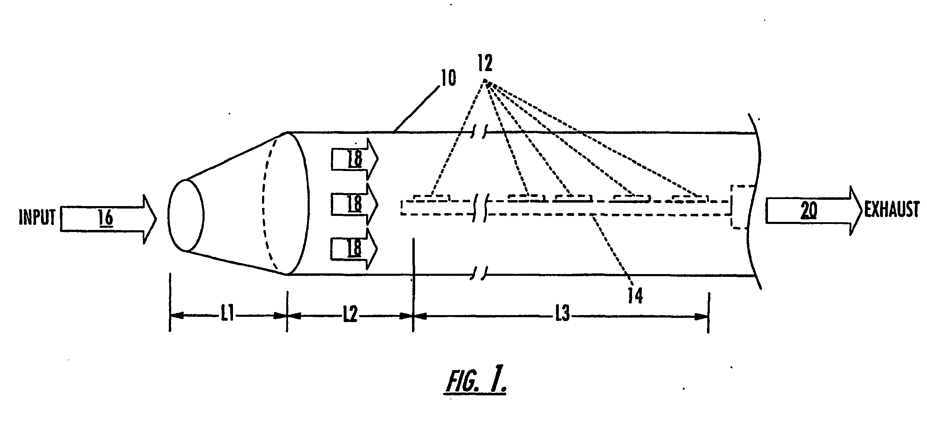

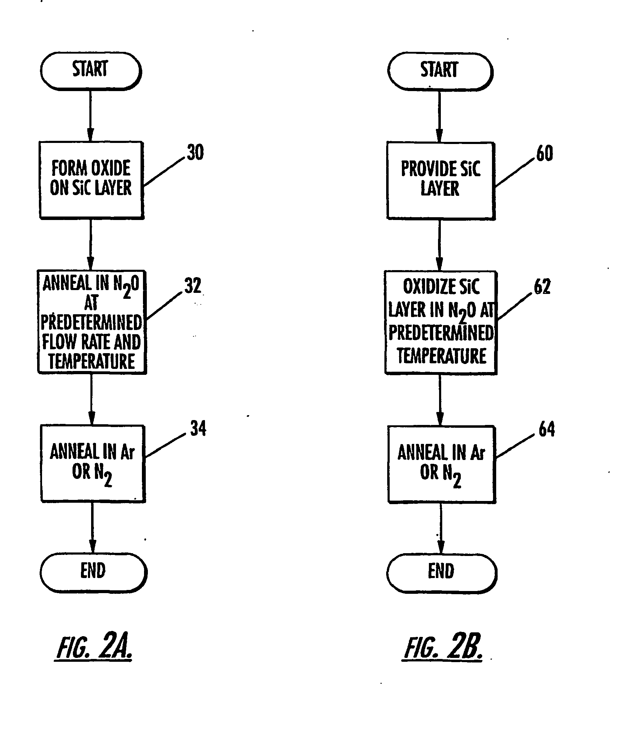

Embodiments of the present invention will now be described with reference to **Figures 1****,** **2A** and **2B** which are a schematic illustration of a furnace tube suitable for use in embodiments of the present invention and flow charts illustrating operations according to particular embodiments of the present invention. As seen in **Figure 1****,** the furnace tube **10** has a plurality of wafers **12** of SiC either with an oxide layer, such as SiO₂, formed thereon or on which an oxide layer is to be formed. Preferably, the SiC wafer is 4H-SiC. The wafers **12** are placed on a carrier **14** such that the wafers will, typically have a fixed position in the furnace tube **10.** The carrier **14** is positioned so that the wafers are a distance **L1+L2** from an inlet of the furnace tube **10** and extend for a distance **L3** within the furnace tube **10.** Input gases **16,** include N₂O which provides an N₂O environment as described herein, are passed into the furnace tube **10** and are heated as they traverse the distance **L1** based on a predetermined temperature profile so as to provide the heated gases **18.** The heated gases **18** are maintained at temperatures based on the predetermined temperature profile and traverse the distance **L2** to reach the first of the wafers **12.** The heated gases **18** continue to pass through the furnace tube **10** until they leave the furnace tube **10** through an outlet port as exhaust gases **20.** Thus, the heated gases **18** traverse the distance **L3.** The heated gases **18** are preferably maintained at a substantially constant temperature for the distances **L2** and **L3,** however, as will be appreciated by those of skill in the art in light of the present disclosure, various temperature profiles may also be utilized. Such profiles may include variations in temperature over time or distance. However, the predetermined temperature profile should include either an anneal temperature of greater than about 1100 °C or an oxidation temperature of at least about 1200 °C.

As is seen in **Figure 1****,** the heated gases **18** reach a temperature at which the N₂O begins to break down into its constituents at the end of the **L1** distance. This distance may depend on the physical characteristics of the furnace tube **10,** the predetermined temperature profile and the flow rate profile. After reaching the temperature at which the N₂O begins to break down, the heated gases **18** traverse the distance **L2** before reaching the wafers **12.** The amount of time that it takes the heated gases to traverse the distance **L2** is referred to herein as an "initial residence time." Preferably, the heated gasses are maintained at a substantially constant temperature corresponding to an anneal temperature of greater than about 1100 °C or an oxidation temperature of at least about 1200 °C for the initial residence time. However, as will be appreciated by those of skill in the art, differing heating profiles could be utilized which increase or decrease the initial residence time. It is preferred, however, that the heating profile be rapid such that the initial residence time is substantially the same as the time that the heated gases **18** are maintained at an anneal temperature of greater than about 1100 °C or an oxidation temperature of at least about 1200 °C before traversing the **L3** distance.

The total amount of time that it takes the heated gases **18** to traverse the distance **L2+L3** is referred to herein as the "total residence time." As will be appreciated by those of skill in the art in light of the present disclosure, these residence times depend on the velocity of the heated gases **18** through the furnace tube **10** which may be determined based on the flow rates of the heated gases **18** and the cross-sectional area of the furnace tube **10.** Such velocities may be average velocities, for example, if turbulent flow is achieved, or may be actual velocities, for example, in laminar flow systems. Thus, the term velocity is used herein to refer to both average and actual velocities.

**Figure 2A** illustrates operations according to embodiments of the present invention and will be described with reference to **Figure 1****.** However, as will be appreciated by those of skill in the art in light of the present disclosure, embodiments of the present invention are not limited to the furnace tube embodiment illustrated in **Figure 1** but may be carried out in any system capable of providing the conditions described herein. Turning to **Figure 2A****,** operations may begin by forming an oxide layer on SiC layer (block **30).** The SiC layer may be an epitaxial layer and/or a substrate. Furthermore, the oxide layer may be formed by deposition, such as Low Pressure Chemical Vapor Deposition (LPCVD), thermally grown through a thermal oxidation process and/or formed using other techniques. Preferably, the oxide layer is formed utilizing a wet reoxidation process as described in United States Patent No. 5,972,801, the disclosure of which is incorporated herein by reference as if set forth fully herein. Furthermore, the oxide layer may be formed *in situ* with the subsequent N₂O anneal and *in situ* with the SiC layer and/or it may be formed in a separate chamber.

The oxide layer is then annealed in an N₂O environment at a predetermined temperature and a predetermined flow rate (block 32). Preferably, the oxide is annealed using a predetermined temperature profile which includes an anneal temperature of greater than about 1100 °C in a chamber in which N₂O is supplied at a flow rate profile within predetermined flow rate limits. In further embodiments, the temperature of the anneal is about 1175 °C or higher. In particular embodiments, an anneal temperature of about 1200 °C may be utilized. The flow rate limits of N₂O may be selected based on the particular equipment in which the process is used. However, in particular embodiments the flow rate limits of N₂O may be as low as about 2 Standard Liters per Minute (SLM) or as high as about 8 SLM. In further embodiments, flow rate limits of from about 3 to about 5 SLM may be preferred.

For a 6 inch diameter furnace tube, flow rates of from 2 SLM to 8 SLM result in gas velocities as low as about 0.37 cm/sec or as high as about 1.46 cm/sec or, and flow rates of from 3 to 5 SLM result in velocities of from about 0.55 cm/s to about 0.95 cm/s. In particular, for an **L2** distance of about 12 inches (about 30.48 cm) and an **L3** distance of about 18 inches (about 45.72 cm), such velocities result in an initial residence time of from about 11 seconds to about 45 seconds and a total residence of from about 28 seconds to about 112 seconds. In particular preferred embodiments, the initial residence time is from about 16 seconds to about 31 seconds and a total residence time of from about 41 to about 73 seconds. The N₂O anneal may be carried out for about 3 hours, however, anneals of from about 30 minutes to about 6 hours may also be utilized although longer times may also be utilized.

As is further illustrated in **Figure 2A****,** the N₂O anneal may be followed by an optional anneal (block **34)** in inert gas or gases, such as argon and/or N₂ or combinations thereof. The optional anneal may also be carried out in a hydrogen containing environment, such as H₂ or H₂ in combination with one or more inert gases, such as such as argon and/or N₂ or combinations thereof. Such an anneal may be carried out for about 1 hour, however, anneals of up to about 3 hours or longer may also be utilized.

**Figure 2B** illustrates operations according to further embodiments of the present invention and will be described with reference to **Figure 1****.** However, as will be appreciated by those of skill in the art in light of the present disclosure, embodiments of the present invention are not limited to the furnace tube embodiment illustrated in **Figure 1** but may be carried out in any system capable of providing the conditions described herein. Turning to **Figure 2B****,** operations begin by providing a SiC layer (block **60).** The SiC layer may be an epitaxial layer and/or a substrate. The oxide layer is then formed in an N₂O environment at a predetermined temperature and/or a predetermined flow rate (block **62).**

The oxide layer is formed by oxidizing the SiC wafers **12** using a predetermined temperature profile which includes an oxidation temperature of greater than about 1200 °C in a chamber in which N₂O is supplied at a flow rate profile within predetermined flow rate limits. In further embodiments, the temperature of the oxidation is about 1300 °C. The flow rate limits of N₂O may be selected based on the particular equipment in which the process is used. However, in particular embodiments, the flow rate limits of N₂O may be as low as about 2 Standard Liters per Minute (SLM) or as high as about 6 SLM or higher. In further embodiments, flow rate limits of from about 3.5 SLM to about 4 SLM may be preferred. As used herein, N₂O refers to pure N₂O or N₂O in combination with other oxidizing agents, such as steam, O₂, and/or inert gases.

For a 6 inch diameter furnace tube, flow rates of from about 2 SLM to about 6 SLM result in gas velocities as low as about 0.37 cm/sec or as high as about 1.11 cm/sec. Similarly, for a 6 inch diameter furnace tube, flow rates of from 3.5 SLM to 4 SLM result in velocities of from about 0.65 cm/s to about 0.74 cm/s. In particular, for an **L2** distance of about 12 inches (about 30.48 cm) and an **L3** distance of about 18 inches (about 45.72 cm), such velocities result in an initial residence time of from about 11 seconds to about 33 seconds and a total residence time of from about 28 seconds to about 84 seconds. In particular preferred embodiments, the initial residence time is from about 19 second to about 22 seconds and the total residence time is from about 49 to about 56 seconds. The N₂O oxidation may be carried out for an amount of time dependent on the desired thickness of the oxide layer. For example, oxidation times of about 3 hours or greater may be utilized.

As is further illustrated in **Figure 2B****,** the N₂O oxidation may be followed by an optional anneal (block **34')** in an inert gas, such as argon or N₂. Optionally, the anneal may be carried out in a hydrogen containing environment, such as H₂ or H₂ in combination with one or more inert gases, such as argon and/or N₂ or combinations thereof. Such an anneal may be carried out for about up to 1 hour, however, anneals of up to about 3 hours or longer may also be utilized.

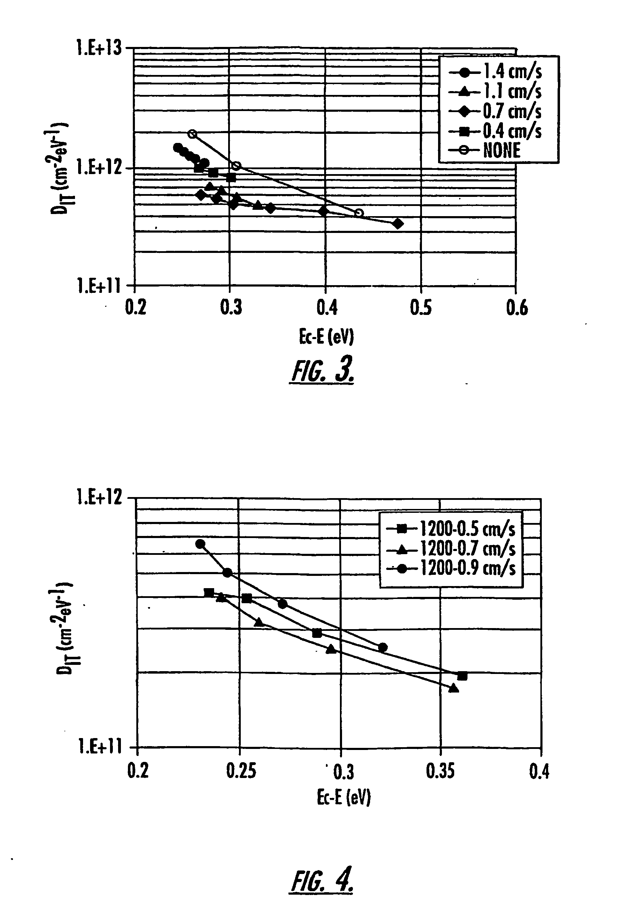

As seen in **Figures 3** through **14****,** it has been found that, by appropriately controlling the anneal and/or oxidation temperature and N₂O flow rate in accordance with the present invention, the SiC/SiO₂ interface quality may be improved, rather than damaged as taught by Lai *et al.*

While not wishing to be bound by any theory of operation, it appears that at high temperatures (above 800°C), a fraction of N₂O will break down into N₂, O₂ and NO. The fraction of NO is determined by the temperature and the amount of time the gas remains at elevated temperatures, which is determined by the flow rate of the gas, the cross-sectional area of the furnace tube and the distances in the tube. Table 1 shows the effect of the flow rate of N₂O on the maximum interface state density for an anneal of 3 hours at 1175°C, followed by a 1 hour Ar anneal after the N₂O anneal.

**Table 1. Effect of Flow Rate on N₂O Anneal.**

| **Flow Rate** | **Maximum Interface State Density (10¹² cm-²eV⁻¹)** |
|---|---|
| no anneal | 2.7 |
| 8 SLM (1.46 cm/s) | 1.5 |
| 6 SLM (1.10 cm/s) | 0.7 |
| 4 SLM (0.73 cm/s) | 0.6 |
| 2 SLM (0.37 cm/s) | 1.0 |

As shown in Table 1, the anneal with 4 SLM of N₂O has the lowest interface state densities, and the most negative flat-band voltage. Accordingly, in particular embodiments of the present invention flow rates of from about 4 to about 6 SLM may be utilized.

**Figures 3** through **10** illustrate the profile of interface trap density (Dit) throughout the bandgap at the SiC/SiO₂ interface for various embodiments of the present invention. D_{IT} may be measured using any technique known to those of skill in the art.

**Figure 3** illustrates the interface trap density versus energy level for various velocities of N₂O for the flow rates in Table 1 with an anneal temperature of 1175 °C. As seen in **Figure 3****,** while each of the flow rates results in a reduced trap density as compared to no N₂O anneal, the greatest reduction in trap density is provided by flow rates yielding velocities of 0.7 cm/s and 1.1 cm/s. **Figure 3** illustrates that the optimal flow rate is approximately 0.7 cm/s (or approximately 4 SLM).

**Figure 4** is a graph of D_{IT} versus energy level for various velocities with an anneal temperature of 1200°C. **Figure 4** likewise indicates that for a 1200°C anneal, the greatest reduction in trap density is achieved with a velocity of approximately 0.7 cm/s (or approximately 4 SLM). Thus, from **Figures 3** and **4****,** initial residence times of about 22 seconds may provide the greatest reduction in trap density.

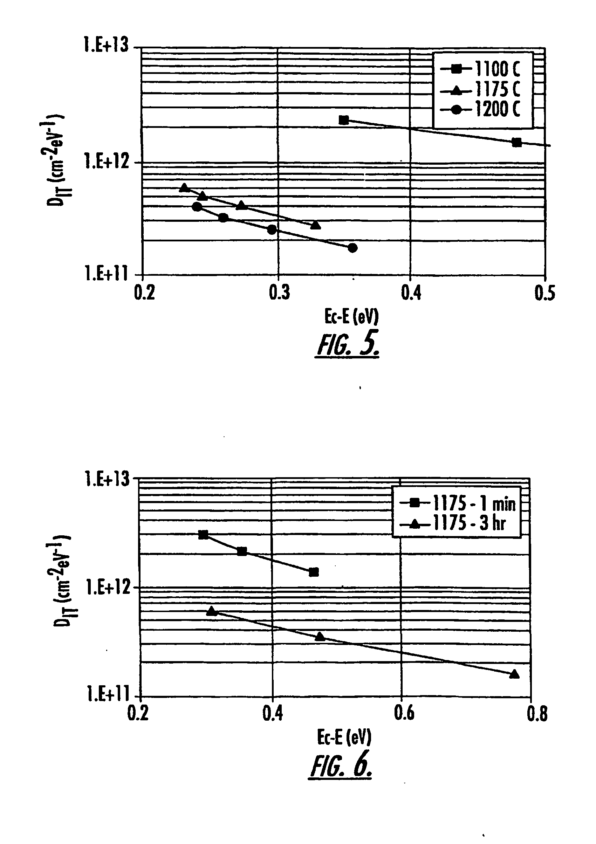

**Figure 5** is a graph of D_{IT} versus energy level for various anneal temperatures.
**Figure 5** illustrates that the temperature should be above 1100°C to obtain a reduction in Dit, and preferably above **1175°C.**

**Figure 6** is a graph of D_{IT} versus energy level at 1175°C for anneals of different durations, namely one minute and three hours. As seen in **Figure 6** a reduction in trap density is achieved by a longer duration anneal (3 hours) over a short duration anneal (1 minute).

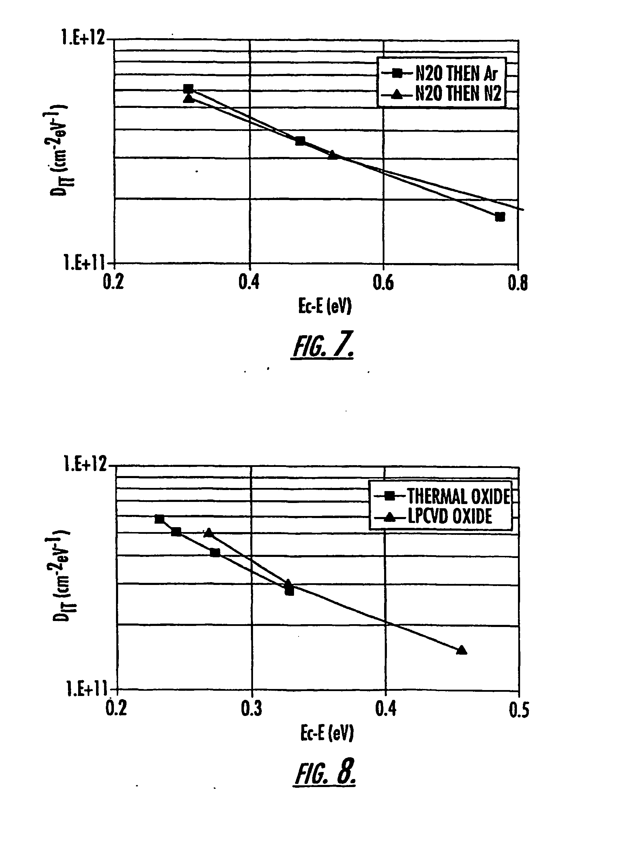

**Figure 7** is a graph of D_{IT} versus energy level for a post-treatment anneal in Ar and N₂. **Figure 7** indicates that both atmospheres are suitable for purposes of the present invention, since they produce substantially similar results.

**Figure 8** is a graph of D_{IT} versus energy level for two different types of oxides, a thermal oxide and an LPCVD oxide. **Figure 8** illustrates that trap densities may be reduced utilizing embodiments of the present invention for both types of oxides as similar results are achieved for both types of oxide.

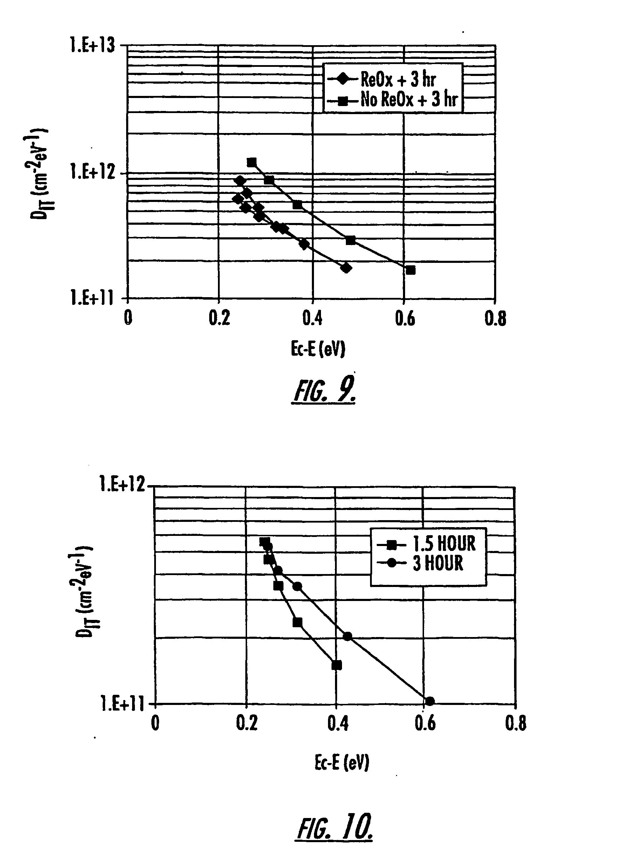

**Figure 9** is a graph of D_{IT} versus energy level for anneal times of 3 hours where the oxide layer included a wet reoxidation as described in United States Patent No. 5,972,801, and for an anneal which did not utilize a wet reoxidation process. As can be seen from **Figure 9****,** decreased interface densities were achieved when a wet re-oxidation process was utilized.

**Figure 10** is a graph of D_{IT} versus energy level for durations of 1.5 and 3 hours. As can be seen from Figure 10, it appears that durations as long as 3 hours may be no more effective, and possible less effective, than durations of about 1.5 hours. However, either duration appears to provide acceptable results.

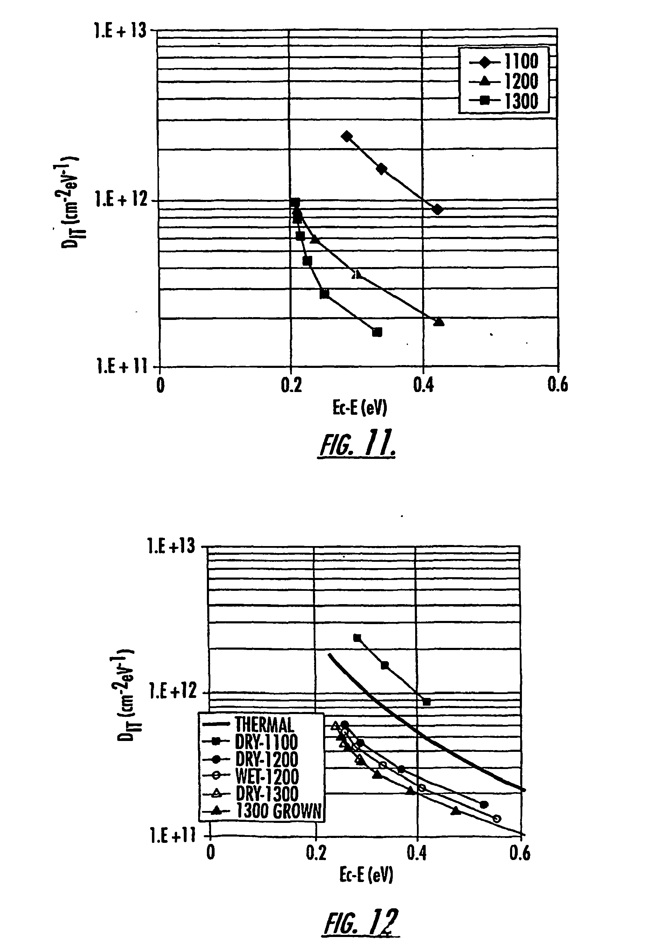

As illustrated in **Figure 11****,** annealing in an N₂O environment at higher temperatures results in better interface characteristics over lower temperature anneals, as it appears that the chemistry yields more of the desired NO, by breaking down the N₂O during the process. This is seen in **Figure 11****,** where N₂O processing at 1100°C, 1200°C and 1300°C are compared. Furthermore, at higher temperatures, the oxidation rate increases significantly. At these higher rates, growing the oxide (as opposed to annealing an existing oxide) in the N₂O ambient would be expected to be feasible. Oxides grown in N₂O at 1300°C have interface characteristics as good or better than SiO₂/SiC interface characteristics reported to date and may significantly reduce the processing time required to separately grow the oxide and anneal it. As seen in **Figure 12****,** the "1300 grown" line illustrates the interface characteristics for an N₂O oxidation process. Such an N₂O oxidation may save several hours of processing time by eliminating the need for both growth and anneal steps.

As described above, SiC devices having an oxide-SiC interface, such as SiC Metal Oxide Semiconductor (MOS) devices may be severely impacted by the large density of interface states present at the SiC/SiO₂ interface. Interface states near the conduction band-edge may be particularly effective at inhibiting SiC device performance. Early improvements in oxidation processes typically reduced interface states only from the valence band to mid-gap. More recent progress has been accomplished using an NO anneal, which may lower the interface state densities near the conduction band-edge. While these improvements using NO annealing may be important, use of this gas in traditional furnaces may not be desirable with the health risks associated with pure NO. As described herein, the use of N₂O has been pursued and effectively developed as an alternative to NO.

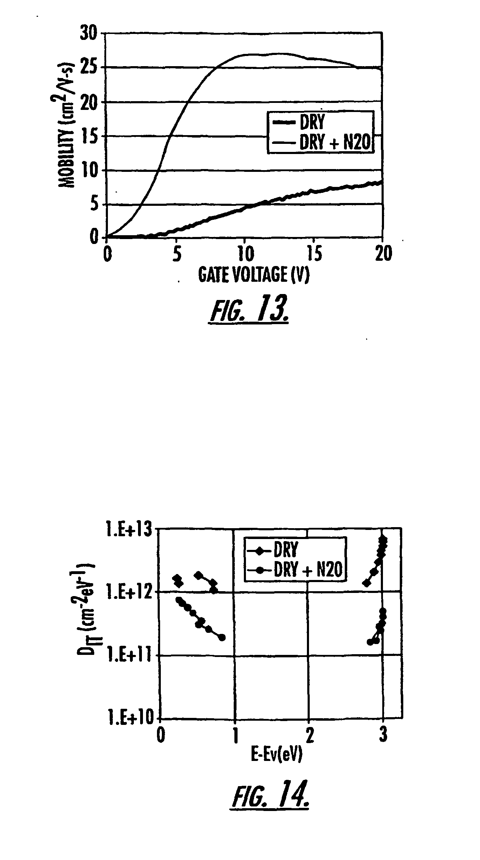

As shown in **Figure 13****,** the temperature of the N₂O processing may be important. At lower temperatures (1100°C), exposing an existing oxide to N₂O increases the interface state density, as shown by comparing the heavy solid line representing a thermal oxide to the data for the same thermal oxide exposed to an 1100°C N₂O anneal. At 1200°C, the thermal oxide is significantly improved with the N₂O anneal. Thermal oxides processed in a wet ambient may be further improved by the 1200°C N₂O anneal, as seen by comparing the solid circle to the open circle data. Further improved results were obtained using a 1300°C N₂O process. At this temperature, the oxidation of SiC is significant. So, in addition to annealing existing oxides in N₂O, some oxides were grown in the N₂O ambient (500 A was grown in 3 hours). Growing the oxide in N₂O may save about 9 hours of processing time over annealing an existing oxide in N₂O, by eliminating the oxidation step. Substantially the same results were obtained regardless of whether the oxide was grown prior to N₂O processing or grown in N₂O.

MOSFETs processed with a 1200°C. N₂O annealed oxide had higher effective surface channel mobility than devices that did not receive the N₂O anneal, as shown in **Figure 13****.** The interface state densities measured on nearby p-type capacitor structures and corresponding n-type capacitors are shown in **Figure 14****.** The reduction in interface state density appears to directly correlate with an improvement in effective surface channel mobility.

In further examples of embodiments of the present invention, two n-type 4H wafers and two p-type 4H wafers were obtained. These four wafers were further divided, such that one wafer from each pair received an implant layer, and epitaxial re-growth to simulate a horizontal channel buffered gate FET (HCBGFET) device while MOSFETs were fabricated on the other wafers. The horizontal channel buffered gate FET devices were fabricated on the selected wafers by a blanket A1 implant and an implant anneal. An additional n-type epi layer was grown on this implanted layer. The Source/Drain regions were implanted and annealed. These wafers were isolated by etching the n-type epi layer in non-device regions. A field oxide was deposited and densified. Active device areas were opened in the field oxide. The gate insulator was grown in N₂O at 1300°C. The gate metal was deposited and patterned. Source/Drain contacts were deposited. Backside Pt was deposited. The contacts were annealed to make them ohmic.

Effective surface channel mobilities and threshold voltages were measured for the MOSFETs. Additionally, "fatFET" devices, which had a gate length of 200 µm and width of 200 µm, were utilized for these measurements as the device characteristics will be dominated by the channel resistance. Table 2 summarizes this fatFET data.

**Table 2. Parameters for MOSFETs with gate oxides thermally grown in N₂O.**

| **Wafer** | **Description** | **Yield** | **V_{T} (V)** | **Mobility (cm²/v-s)** |
|---|---|---|---|---|
| #1 | MOSFET | 80% | 5.6 | 17.8(20.0) |
| #2 | MOSFET | 82% | 4.9 | 21.2 (24.0) |
| #3 | HCBGFET | 89% | 1.3 | 96.9 (230) |
| #4 | HCBGFET | 98% | 1.9 | 72.3 (240) |
| #3 | HCBGFET only *normally-off* | 58% | 1.8 | 55.5 (99.0) |
| #4 | HCBGFET only *normally-off* | 70% | 2.5 | 41.0 (75.0) |

In Table 2, the averages are given, with the highest effective surface channel mobility being given in parenthese. Ten columns and seven rows (less four corners) were probed = 66 total.

The horizontal channel buffered gate devices exhibited high effective surface channel mobilities, but the highest mobilities corresponded with normally-on devices, which is undesirable. More appropriate statistics are shown in the last two rows where all normally-on devices have been excluded from the calculations.

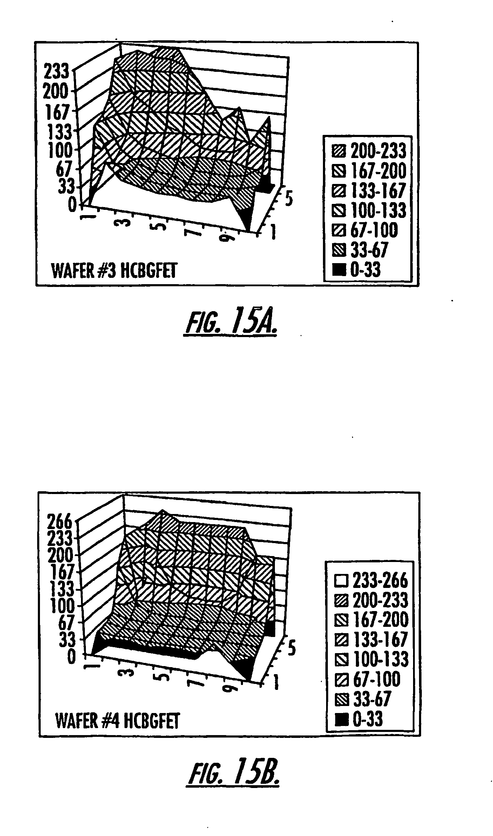

Even eliminating the normally-on devices, the HCBGFET results indicate improvement over conventional oxide processes. One wafer exhibited an average effective surface channel mobility of 55.5 cm²/V-s, with a maximum of 99 cm²/V-s, while the other wafer has an average effective surface channel mobility of 41 cm²/V-s, with a maximum of 75 cm²/V-s. The variation is likely due to the variation in the doping of the epitaxial layer. This variation is shown in **figures 15A** and **15B. Figures 15A** and **15B** illustrate the effective Surface Channel Mobility across Wafers #3 **(****Figure 15A****)** and #4 **(****Figure 15B****).** The doping was higher on the edge of the wafer, turning the device normally-on, and producing very high mobilities.

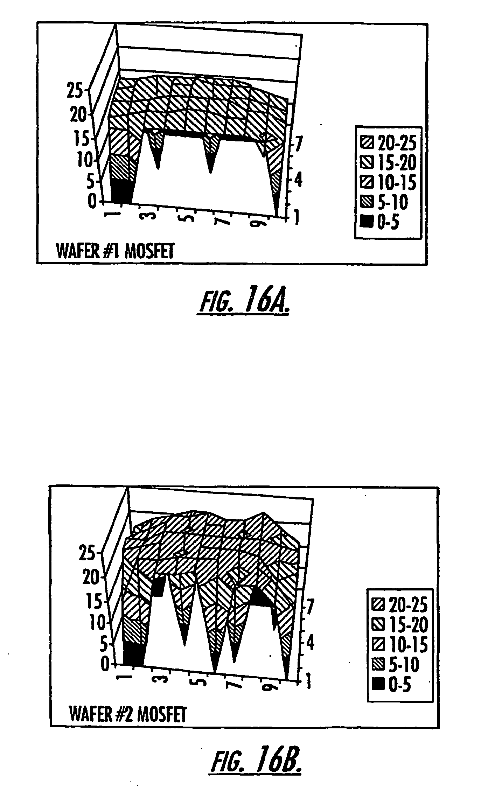

The lateral MOSFETs did not show the same degree of variation in mobility as the HCBGFETs as is shown in **Figures 16A** and **16B. Figures 16A** and **16B** are graphs of the effective Surface Channel Mobility across Wafers #1 **(****Figure 16A****)** and #2 **(****Figure 16B****).** As seen in **Figures 16A** and **16B****,** the mobility was very uniform across the wafer, except for the occasional non-yielding device. Typically, 4H-SiC MOSFETs with thermal or deposited oxides without NO or N₂O processing typically had mobilities in the single digits. The reduction of interface states obtained by growing the oxide in N₂O has effectively increased by a factor of tenthe surface channel mobility.

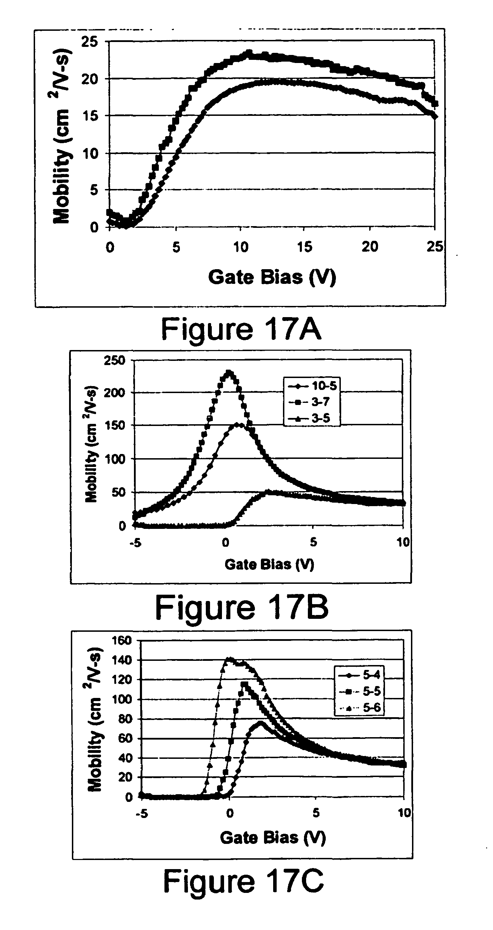

The mobility of these lateral MOSFETs may be important because the HCBGFET mobility is believed to be limited by this surface mobility at high fields. The mobility at different gate biases is shown in **Figures 17A,17B** and **17C****.** Notice that at high gate biases, there is very little difference between the MOSFETs of wafers #1 and #2, in **Figure 17A****,** and the HCBGFETs of wafers #3 **(****Figure 17B****)** and #4 **(****Figure 17C****).**

As is illustrated in the above example, improved effective surface channel mobility may be provided in MOSFETs with gate oxides grown in N₂O. Standard lateral devices have mobilities around 20 cm²/v-s. HCBGFET mobilities as high as 240 cm²/v-s have been obtained on normally-on devices and 99 cm²/v-s for normally-off devices. Furthermore, as is illustrated by **Figures 3-17C** above, through use of embodiments of the present invention, interface trap densities for oxide layers formed on silicon carbide may be reduced utilizing an N₂O oxidation and/or anneal without the need for a subsequent wet O₂ anneal. Additionally, the N₂O oxidation may be carried out with other gases in the ambient as described above. Also, N₂O oxidation may be followed by N₂O anneal as described in commonly assigned United States Patent Application Serial No. 09/834,283, entitled "METHOD OF N₂O ANNEALING AN OXIDE LAYER ON A SILICON CARBIDE LAYER", filed April 12, 2001, published as US 2002172774-A1.

In the drawings and specification, there have been disclosed typical preferred embodiments of the invention and, although specific terms are employed, they are used in a generic and descriptive sense only and not for purposes of limitation, the scope of the invention being set forth in the following claims.

## Claims

1. A method of fabricating a silicon carbide structure having a silicon carbide layer and an oxide layer on the silicon carbide layer, the method being **characterized by** at least one of:
annealing an existing oxide layer in a heated furnace tube (10) in an environment comprising N₂O using a predetermined temperature profile which includes an anneal temperature of greater than 1100°C and a flow rate profile which includes a flow rate which provides an initial residence time of the N₂O of at least 11 seconds; or
oxidising a layer of silicon carbide in a heated furnace in an N₂O environment using a predetermined temperature profile which includes an oxidation temperature of at least 1200°C utilizing a flow rate profile of N₂O which includes a flow rate which provides an initial residence time of the N₂O of at least 11 seconds, said initial residence time being defined in each case as the time taken by heated gases flowing in through the furnace tube to reach the silicon carbide layer after reaching the temperature at which the N₂O begins to break down into its constituents.

2. A method according the Claim 1, wherein the method is **characterized by** oxidizing a layer of silicon carbide.

3. A method according to Claim 1 or 2, wherein the method is **characterized by** annealing an existing oxide layer.

4. A method according to Claim 3, wherein the initial residence time is from 11 seconds to 45 seconds.

5. A method according to Claim 4, wherein the initial residence time is from 26 seconds to 31 seconds.

6. A method according to Claim 3, wherein a total residence time of the N₂O, from when it begins to break down into its constituents to when it flows away from the silicon carbide layer, is from 28 seconds to 112 seconds.

7. A method according to Claim 6, wherein the total residence time of the N₂O is from 41 seconds to 73 seconds.

8. A method according to Claim 3, wherein the anneal temperature is at least 1175°C.

9. A method according to Claim 8, wherein the anneal temperature is about 1200°C.

10. A method according to Claim 3, wherein the flow rate profile provides a flow rate of from 2 standard Liters per Minute (SLM) to 8 SLM.

11. A method according to Claim 10, wherein the flow rate profile provides a flow rate of from 3 to 5 Standard Liters per Minute.

12. A method according to Claim 3, wherein the step of annealing the existing oxide layer is carried out for about 3 hours.

13. A method according to Claim 3, wherein the step of annealing the existing oxide layer is carried out for about 1.5 hours.

14. A method according to Claim 1, wherein the step of annealing the existing oxide layer or the step of oxidizing is followed by the step of annealing in an inert gas environment.

15. A method according to Claim 1, wherein the step of annealing the existing oxide layer or the step of oxidizing is followed by the step of annealing in an environment comprising at least one ofAr, N₂ and H₂.

16. A method according to Claim 14, wherein the step of annealing in an inert gas environment is carried out for about one hour.

17. A method according to Claim 3 wherein the flow rate profile provides a velocity of the N₂O of from 0.37 cm/s to 1.46 cm/s.

18. A method according to Claim 17, wherein the flow rate profile provides a velocity of the N₂O of from 1.5cm/s to 1 cm/s.

19. A method according to Claim 3, wherein the oxide layer is formed by thermally growing the oxide layer.

20. A method according to Claim 3, wherein the oxide layer is formed by performing a wet reoxidation of the oxide layer.

21. A method according to Claim 1, wherein the silicon carbide layer comprises 4H polytype silicon carbide.

22. The method according to Claim 2, wherein said initial residence time is from 11 seconds to 33 seconds.

23. The method according to Claim 22, wherein said initial residence time is from 19 seconds to 22 seconds.

24. The method according to Claim 2, wherein the total residence time of the N₂O is from 28 seconds to 84 seconds.

25. The method according to Claim 24, wherein the total residence time of the N₂O is from 49 seconds to 56 seconds.

26. The method according to Claim 2, wherein the oxidation temperature is about 1300°C.

27. The method according to Claim 2, wherein the flow rate profile provides a flow rate of from 2 Standard Liters per Minute (SLM) to 6 SLM.

28. The method according to Claim 27, wherein the flow rate profile provides a flow rate of from 3.5 to 4 Standard Liters per Minute.

29. The method according to Claim 2, wherein the predetermined flow rate provides a velocity of the N₂O of from 0.37 cm/s to 1,11 cm/s.

30. The method according to Claim 27,wherein the predetermined flow rate provides a velocity of N₂O of from 0.65 cm/s to 0.74 cm/s.

31. The method according to Claim 2, wherein the step of oxidizing the silicon carbide layer comprises oxidizing the silicon carbide layer in an environment comprising N₂O and including at least one of oxidizing agents and inert gases.

32. The method of Claim31, wherein the oxidizing agents comprise at last one of steam and O₂.

33. The method according to Claim 1, wherein the silicon carbide layer comprises a silicon carbide layer on a non-silicon carbide substrate.

## Patentansprüche

1. Verfahren zur Herstellung einer Siliziumkarbidstruktur, die eine Siliziumkarbidschicht und eine Oxidschicht auf der Siliziumkarbidschicht aufweist, wobei das Verfahren **gekennzeichnet ist durch** mindestens eines von:
Glühen einer vorhandenen Oxidschicht in einem beheizten Rohrofen (10) in einer Umgebung, die N₂O umfasst, wobei ein vorbestimmtes Temperaturprofil verwendet wird, das eine Glühtemperatur von größer als 1100°C umfasst, und ein Flussraten-Profil, das eine Flussrate umfasst, die eine anfängliche Verweilzeit des N₂O von mindestens 11 Sekunden, bereitstellt; oder
Oxidieren einer Schicht von Siliziumkarbid in einem beheizten Ofen in einer N₂O-Umgebung, wobei ein vorbestimmtes Temperaturprofil verwendet wird, das eine Oxidationstemperatur von mindestens 1200°C umfasst, wobei ein Flussraten-Profil von N₂O verwendet wird, das eine Flussrate umfasst, die eine anfängliche Verweilzeit des N₂O von mindestens 11 Sekunden, bereitstellt, wobei die anfängliche Verweilzeit jeweils als die Zeit definiert ist, die erhitzte Gase, die **durch** den Rohrofen einfließen, benötigen, um die Siliziumkarbidschicht zu erreichen, nachdem sie die Temperatur erreicht haben, bei der N₂O anfängt, sich in seine Bestandteile aufzuspalten.

2. Verfahren gemäß Anspruch 1, wobei das Verfahren durch das Oxidieren einer Schicht von Siliziumkarbid **gekennzeichnet** ist.

3. Verfahren gemäß Anspruch 1 oder 2, wobei das Verfahren durch das Glühen einer vorhandenen Oxidschicht **gekennzeichnet** ist.

4. Verfahren gemäß Anspruch 3, wobei die anfängliche Verweilzeit von 11 Sekunden bis 45 Sekunden ist.

5. Verfahren gemäß Anspruch 4, wobei die anfängliche Verweilzeit von 26 Sekunden bis 31 Sekunden ist.

6. Verfahren gemäß Anspruch 3, wobei eine gesamte Verweilzeit des N₂O, von dem Zeitpunkt, wenn es anfängt, sich in seine Bestandteile aufzuspalten, bis zu dem Zeitpunkt, wenn es von der Siliziumkarbidschicht wegfließt, von 28 Sekunden bis 112 Sekunden ist.

7. Verfahren gemäß Anspruch 6, wobei die gesamte Verweilzeit des N₂O von 41 Sekunden bis 73 Sekunden ist.

8. Verfahren gemäß Anspruch 3, wobei die Glühtemperatur mindestens 1175°C ist.

9. Verfahren gemäß Anspruch 8, wobei die Glühtemperatur etwa 1200°C ist.

10. Verfahren gemäß Anspruch 3, wobei das Flussraten-Profil eine Flussrate von 2 Standard-Litern pro Minute (SLM) bis 8 SLM bereitstellt.

11. Verfahren gemäß Anspruch 10, wobei das Flussraten-Profil eine Flussrate von 3 bis 5 Standard-Litern pro Minute bereitstellt.

12. Verfahren gemäß Anspruch 3, wobei der Schritt Glühen der vorhandenen Oxidschicht für etwa 3 Stunden durchgeführt wird.

13. Verfahren gemäß Anspruch 3, wobei der Schritt Glühen der vorhandenen Oxidschicht für etwa 1,5 Stunden durchgeführt wird.

14. Verfahren gemäß Anspruch 1, wobei auf den Schritt Glühen der vorhandenen Oxidschicht oder auf den Schritt Oxidieren der Schritt Glühen in einer Inertgasumgebung folgt.

15. Verfahren gemäß Anspruch 1, wobei auf den Schritt Glühen der vorhandenen Oxidschicht oder auf den Schritt Oxidieren der Schritt Glühen in einer Umgebung, die mindestens eines von Ar, N₂ und H₂ umfasst, folgt.

16. Verfahren gemäß Anspruch 14, wobei der Schritt Glühen in einer Inertgasumgebung für etwa eine Stunde durchgeführt wird.

17. Verfahren gemäß Anspruch 3, wobei das Flussraten-Profil eine Geschwindigkeit des N₂O von 0,37 cm/s bis 1,46 cm/s bereitstellt.

18. Verfahren gemäß Anspruch 17, wobei das Flussraten-Profil eine Geschwindigkeit des N₂O von 1,5 cm/s bis 1 cm/s bereitstellt.

19. Verfahren gemäß Anspruch 3, wobei die Oxidschicht durch thermisches Aufwachsen der Oxidschicht gebildet wird.

20. Verfahren gemäß Anspruch 3, wobei die Oxidschicht mittels Durchführung einer Nass-Reoxidation der Oxidschicht gebildet wird.

21. Verfahren gemäß Anspruch 1, wobei die Siliziumkarbidschicht Siliziumkarbid vom Polytyp 4H umfasst.

22. Verfahren gemäß Anspruch 2, wobei die anfängliche Verweilzeit von 11 Sekunden bis 33 Sekunden ist.

23. Verfahren gemäß Anspruch 22, wobei die anfängliche Verweilzeit von 19 Sekunden bis 22 Sekunden ist.

24. Verfahren gemäß Anspruch 2, wobei die gesamte Verweilzeit des N₂O von 28 Sekunden bis 84 Sekunden ist.

25. Verfahren gemäß Anspruch 24, wobei die gesamte Verweilzeit des N₂O von 49 Sekunden bis 56 Sekunden ist.

26. Verfahren gemäß Anspruch 2, wobei die Oxidationstemperatur etwa 1300°C ist.

27. Verfahren gemäß Anspruch 2, wobei das Flussraten-Profil eine Flussrate von 2 Standard-Litern pro Minute (SLM) bis 6 SLM bereitstellt.

28. Verfahren gemäß Anspruch 27, wobei das Flussraten-Profil eine Flussrate von 3,5 bis 4 Standard-Litern pro Minute bereitstellt.

29. Verfahren gemäß Anspruch 2, wobei die vorbestimmte Flussrate eine Geschwindigkeit des N₂O von 0,37 cm/s bis 1,11 cm/s bereitstellt.

30. Verfahren gemäß Anspruch 27, wobei die vorbestimmte Flussrate eine Geschwindigkeit des N₂O von 0,65 cm/s bis 0,74 cm/s bereitstellt.

31. Verfahren gemäß Anspruch 2, wobei der Schritt Oxidieren der Siliziumkarbidschicht das Oxidieren der Siliziumkarbidschicht in einer Umgebung, umfassend N₂O und umfassend mindestens eines aus Oxidationsmitteln und Inertgasen, umfasst.

32. Verfahren nach Anspruch 31, wobei die Oxidationsmittel mindestens eines von Dampf und O₂ umfassen.

33. Verfahren gemäß Anspruch 1, wobei die Siliziumkarbidschicht eine Siliziumkarbidschicht auf einem Nicht-Siliziumkarbidsubstrat umfasst.

## Revendications

1. Procédé de fabrication d'une structure de carbure de silicium présentant une couche de carbure de silicium et une couche d'oxyde sur la couche de carbure de silicium, le procédé étant **caractérisé par** au moins l'une des étapes qui consistent:
à recuire une couche d'oxyde existante dans un four tubulaire chauffé (10) dans un environnement comprenant le N₂O en utilisant un profil de température prédéterminé qui comprend une température de recuit qui est supérieure à 1100°C et un profil de débit qui comprend un débit qui prévoit un temps de séjour initial du N₂O d'au moins 11 secondes ; ou
à oxyder une couche de carbure de silicium dans un four chauffé dans un environnement de N₂O en utilisant un profil de température prédéterminé qui comprend une température d'oxydation d'au moins 1200°C en utilisant un profil de débit du N₂O qui comprend un débit qui prévoit un temps de séjour initial du N₂O d'au moins 11 secondes, ledit temps de séjour initial étant défini dans chaque cas comme étant le temps nécessaire pour que des gaz chauffés circulant à travers le four tubulaire atteignent la couche de carbure de silicium après avoir atteint la température à laquelle le N₂O commence à se décomposer en ses constituants.

2. Procédé selon la revendication 1, dans lequel le procédé est **caractérisé par** l'oxydation d'une couche de carbure de silicium.

3. Procédé selon la revendication 1 ou 2, dans lequel le procédé est **caractérisé par** le recuit d'une couche d'oxyde existante.

4. Procédé selon la revendication 3, dans lequel le temps de séjour initial est de 11 secondes à 45 secondes.

5. Procédé selon la revendication 4, dans lequel le temps de séjour initial est de 26 secondes à 31 secondes.

6. Procédé selon la revendication 3, dans lequel un temps de séjour total du N₂O, à partir du moment où il commence à se décomposer en ses constituants lorsqu'il quitte la couche de carbure de silicium, est de 28 secondes à 112 secondes.

7. Procédé selon la revendication 6, dans lequel le temps de séjour total du N₂O est de 41 secondes à 73 secondes.

8. Procédé selon la revendication 3, dans lequel la température de recuit est au moins 1175°C.

9. Procédé selon la revendication 8, dans lequel la température de recuit est d'environ 1200°C.

10. Procédé selon la revendication 3, dans lequel le profil de débit prévoit un débit de 2 litres standard par minute (SLM) à 8 SLM.

11. Procédé selon la revendication 10, dans lequel le profil de débit prévoit un débit de 3 à 5 litres standard par minute.

12. Procédé selon la revendication 3, dans lequel l'étape de recuit de la couche d'oxyde existante est exécutée pendant environ 3 heures.

13. Procédé selon la revendication 3, dans lequel l'étape de recuit de la couche d'oxyde existante est exécutée pendant environ 1,5 heure.

14. Procédé selon la revendication 1, dans lequel l'étape de recuit de la couche d'oxyde existante ou l'étape d'oxydation est suivie par l'étape de recuit dans un environnement de gaz inerte.

15. Procédé selon la revendication 1, dans lequel l'étape de recuit de la couche d'oxyde existante ou l'étape d'oxydation est suivie par l'étape de recuit dans un environnement comprenant au moins l'un de l'Ar, du N₂ et du H₂.

16. Procédé selon la revendication 14, dans lequel l'étape de recuit dans un environnement de gaz inerte est exécutée pendant environ une heure.

17. Procédé selon la revendication 3, dans lequel le profil de débit prévoit une vitesse du N₂O de 0,37 cm/s à 1,46 cm/s.

18. Procédé selon la revendication 17, dans lequel le profil de débit prévoit une vitesse du N₂O de 1,5 cm/s à 1 cm/s.

19. Procédé selon la revendication 3, dans lequel la couche d'oxyde est formée par la croissance thermique de la couche d'oxyde.

20. Procédé selon la revendication 3, dans lequel la couche d'oxyde est formée en exécutant une réoxydation en phase humide de la couche d'oxyde.

21. Procédé selon la revendication 1, dans lequel la couche de carbure de silicium comprend le carbure de silicium de polytype 4H.

22. Procédé selon la revendication 2, dans lequel ledit temps de séjour initial est de 11 secondes à 33 secondes.

23. Procédé selon la revendication 22, dans lequel ledit temps de séjour initial est de 19 secondes à 22 secondes.

24. Procédé selon la revendication 2, dans lequel le temps de séjour total du N₂O est de 28 secondes à 84 secondes.

25. Procédé selon la revendication 24, dans lequel le temps de séjour total du N₂O est de 49 secondes à 56 secondes.

26. Procédé selon la revendication 2, dans lequel la température d'oxydation est d'environ 1300°C.

27. Procédé selon la revendication 2, dans lequel le profil de débit prévoit un débit de 2 litres standard par minute (SLM) à 6 SLM.

28. Procédé selon la revendication 27, dans lequel le profil de débit prévoit un débit de 3,5 à 4 litres standard par minute.

29. Procédé selon la revendication 2, dans lequel le débit prédéterminé prévoit une vitesse du N₂O de 0,37 cm/s à 1,11 cm/s.

30. Procédé selon la revendication 27, dans lequel le débit prédéterminé prévoit une vitesse du N₂O de 0,65 cm/s à 0,74 cm/s.

31. Procédé selon la revendication 2, dans lequel l'étape d'oxydation de la couche de carbure de silicium comprend l'oxydation de la couche de carbure de silicium dans un environnement comprenant le N₂O et comportant au moins l'un des agents d'oxydation et l'un des gaz inertes.

32. Procédé selon la revendication 31, dans lequel les agents d'oxydation comprennent au moins l'un de la vapeur et du O₂.

33. Procédé selon la revendication 1, dans lequel la couche de carbure de silicium comprend une couche de carbure de silicium sur un substrat de carbure exempt de silicium.
